(19) **Europäisches Patentamt**
**European Patent Office**
**Office européen des brevets**

(11) **EP 4 421 511 A1**

(12) # EUROPEAN PATENT APPLICATION
published in accordance with Art. 153(4) EPC

(43) Date of publication:
**28.08.2024 Bulletin 2024/35**

(21) Application number: **22882505.5**

(22) Date of filing: **14.09.2022**

(51) International Patent Classification (IPC):
**G01R 33/09** (2006.01)    **G01R 33/02** (2006.01)

(86) International application number:
**PCT/CN2022/118641**

(87) International publication number:
**WO 2023/065894 (27.04.2023 Gazette 2023/17)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **18.10.2021 CN 202111211408**

(71) Applicant: **MultiDimension Technology Co., Ltd.**
**Jiangsu 215634 (CN)**

(72) Inventors:
• **GUO, Haiping**
**Zhangjiagang, Jiangsu 215634 (CN)**

• **SONG, Chen**
**Zhangjiagang, Jiangsu 215634 (CN)**
• **CHEN, Ye**
**Zhangjiagang, Jiangsu 215634 (CN)**
• **SHEN, Weifeng**
**Zhangjiagang, Jiangsu 215634 (CN)**
• **XUE, Songsheng**
**Zhangjiagang, Jiangsu 215634 (CN)**

(74) Representative: **HGF**
**HGF Limited**
**1 City Walk**
**Leeds LS11 9DX (GB)**

(54) **MAGNETIC SENSOR APPARATUS**

(57)    Embodiments of the present invention disclose a magnetic apparatus. The apparatus comprises a magnetic field generation portion, a magnetic sensor portion and a signal processing portion. The magnetic sensor portion comprises a first magnetic sensor arranged at a first position, a second magnetic sensor arranged at a second position and a third magnetic sensor arranged at a third position. The first position, the second position and the third position are on the same horizontal line and are arranged at equal intervals. Magnetic fields generated by the magnetic field generation portion at the three different positions are different. The signal processing portion comprises a first differential circuit, a second differential circuit, and a third differential circuit. The first differential circuit generates a first difference between the first signal that is sensed and output by the first magnetic sensor and the second signal sensed and output by the second magnetic sensor. The second differential circuit generates a second difference between the second signal and the third signal sensed and output by the third magnetic sensor. The third differential circuit generates a differential measurement signal on the basis of the difference between the first difference and the second difference. The magnetic sensor apparatus can eliminate the impact of a magnetic interfering field to improve the current detection precision.

FIG. 4

**Description**

**Technical Field**

Embodiments of the present invention relate to the field of magnetic sensor technologies, and in particular, to a magnetic sensor apparatus.

**Background**

Current measurement has always been a common and important requirement in industries such as power system, wind power, photovoltaics, frequency converter, rail transit, and industrial control. Now, with the booming development of artificial intelligence and smart Internet of Things, the demand for current measurement will increase significantly, and at the same time, it also poses higher challenges to the miniaturization, high sensitivity, and precision of a current measurement module.

A current sensor detects the magnitude of a measured current by detecting the size of a magnetic field generated by the current. However, there is often a magnetic interfering field in the environment, so that the sensor is low in sensitivity and unstable in performance. In order to reduce the impact of the magnetic interfering field, a magnetic shielding method may be used to improve the detection precision. An embodiment of a current sensor is proposed in the patent No. CN109313223A entitled "CURRENT SENSOR", which includes at least two magnetic shields arranged around a magnetic detection element and configured to sandwich the magnetic detection element and a current path, thereby shielding the impact of external magnetic flux on the magnetic detection element. The magnetic shield often makes the sensor size larger and the system more complex, and therefore, in addition to this, sensor configuration and circuit processing may also be used to reduce the impact of a magnetic interfering field. The patent No. CN111308154A entitled "CURRENT SENSOR" includes two sensors located at different physical positions, the processing circuit is connected to the magnetic sensors, and a current is determined on the basis of a signal difference between the two sensors such that the current sensor is insensitive to an external interfering field.

The above processing circuit can only handle the situation where the magnetic interfering field is a uniform-intensity external field. In practical applications, the forms of external interfering fields are often diverse, especially non-uniform external fields are most common. The interference of a non-uniform external field on the sensor affects the detection precision.

**Summary of the Invention**

The embodiments of the present invention provide a magnetic sensor apparatus to solve the problem that an existing current sensor is interfered by a magnetic interfering field.

An embodiment of the present invention provides a magnetic sensor apparatus, including:

a magnetic field generation portion, the magnetic field generation portion being used for generating a magnetic field;
a magnetic sensor portion, the magnetic sensor portion being used for sensing the magnetic field generated by the magnetic field generation portion; and
a signal processing portion, the signal processing portion being used for processing a magnetic field signal sensed by the magnetic sensor portion;
wherein the magnetic sensor portion includes a first magnetic sensor arranged at a first position, a second magnetic sensor arranged at a second position, and a third magnetic sensor arranged at a third position, and magnetic fields generated by the magnetic field generation portion at the three different positions are different; and
the signal processing portion includes a first differential circuit, a second differential circuit, and a third differential circuit, the first differential circuit generates a first difference between a first signal sensed and output by the first magnetic sensor and a second signal sensed and output by the second magnetic sensor, the second differential circuit generates a second difference between the second signal and a third signal sensed and output by the third magnetic sensor, and the third differential circuit generates a differential measurement signal on the basis of a difference between the first difference and the second difference.

Further, the first position, the second position, and the third position are on the same horizontal line and are arranged at equal intervals.

Further, the magnetic sensor portion includes a plurality of magnetic sensors, wherein sensing directions of the various magnetic sensors are parallel or anti-parallel.

Further, the magnetic field generation portion includes an energized wire or a permanent magnet for generating a regular magnetic field.

Further, the magnetic sensor portion and the signal processing portion are integrated and packaged into an independent device; or,
the magnetic field generation portion, the magnetic sensor portion, and the signal processing portion are integrated and packaged into an independent device.

An embodiment of the present invention further provides a magnetic sensor apparatus, including:

a magnetic field generation portion, the magnetic field generation portion being used for generating a magnetic field;
a magnetic sensor portion, the magnetic sensor portion being used for sensing the magnetic field generated by the magnetic field generation portion; and
a signal processing portion, the signal processing portion being used for processing a magnetic field signal sensed by the magnetic sensor portion;
wherein the magnetic sensor portion includes a first magnetic sensor arranged at a first position, a second magnetic sensor arranged at a second position, a third magnetic sensor arranged at a third position, and a fourth magnetic sensor arranged at a fourth position;
magnetic fields generated by the magnetic field generation portion at the four different positions are different; and
the signal processing portion includes a first differential circuit, a second differential circuit, and a third differential circuit, the first differential circuit generates a first difference between a first signal sensed and output by the first magnetic sensor and a second signal sensed and output by the second magnetic sensor, the second differential circuit generates a second difference between a third signal sensed and output by the third magnetic sensor and a fourth signal sensed and output by the fourth magnetic sensor, and the third differential circuit generates a differential measurement signal on the basis of a difference between the first difference and the second difference; or,
the first differential circuit generates a first difference between a first signal sensed and output by the first magnetic sensor and a third signal sensed and output by the third magnetic sensor, the second differential circuit generates a second difference between a second signal sensed and output by the second magnetic sensor and a fourth signal sensed and output by the fourth magnetic sensor, and the third differential circuit generates a differential measurement signal on the basis of a difference between the first difference and the second difference.

Further, the first position, the second position, the third position, and the fourth position are on the same horizontal line and are arranged at equal intervals, or, an interval between the first position and the third position is the same as an interval between the second position and the fourth position, and the interval between the first position and the third position is greater than an interval between the first position and the second position.

Further, the magnetic sensor portion includes a plurality of magnetic sensors, wherein sensing directions of the various magnetic sensors are parallel or anti-parallel.

Further, the magnetic field generation portion includes an energized wire or a permanent magnet for generating a regular magnetic field.

Further, the magnetic sensor portion and the signal processing portion are integrated and packaged into an independent device; or,
the magnetic field generation portion, the magnetic sensor portion, and the signal processing portion are integrated and packaged into an independent device.

The magnetic sensor apparatus provided by the embodiment of the present invention may be used to eliminate the impact of a magnetic interfering field on current measurement. An output signal of the magnetic sensor usually includes a measured magnetic field and a magnetic interfering field, and the magnetic interfering field includes a uniform magnetic interfering field and a non-uniform magnetic interfering field. In the embodiment of the present invention, the use of magnetic sensors located at N positions and a compensation algorithm can simultaneously eliminate the uniform magnetic interfering field and the non-uniform magnetic interfering field, thereby improving the anti-interference ability and current detection precision of the current sensor.

**Description of the Drawings**

In order to more clearly illustrate the technical solutions in the embodiments of the present invention or the prior art, the drawings required for use in the embodiments or the prior art are briefly introduced below. Obviously, although the drawings described below are some specific embodiments of the present invention, for those skilled in the art, the basic concepts of the device structure, driving method, and manufacturing method disclosed and prompted by the various embodiments of the present invention can be expanded and extended to other structures and drawings, and there is no doubt that these should fall within the scope of the claims of the present invention.

FIG. 1 is a schematic connection diagram of magnetic resistors in an existing single current sensor;
FIG. 2 is a schematic connection diagram of magnetic resistors in another existing single current sensor;

FIG. 3 is a schematic diagram of a magnetic sensor apparatus according to an embodiment of the present invention;

FIG. 4 is a schematic diagram of another magnetic sensor apparatus according to an embodiment of the present invention;

FIG. 5 is a schematic diagram of still another magnetic sensor apparatus according to an embodiment of the present invention;

FIG. 6 is a schematic diagram of still another magnetic sensor apparatus according to an embodiment of the present invention;

FIG. 7 is a schematic diagram of still another magnetic sensor apparatus according to an embodiment of the present invention;

FIG. 8a is a schematic diagram of an energized wire;

FIG. 8b is a schematic diagram of another energized wire;

FIG. 8c is a schematic diagram of still another energized wire;

FIG. 9a is a schematic diagram of still another magnetic sensor apparatus according to an embodiment of the present invention;

FIG. 9b is a schematic diagram of still another magnetic sensor apparatus according to an embodiment of the present invention; and

FIG. 10 is a schematic diagram of still another magnetic sensor apparatus according to an embodiment of the present invention.

**Detailed Description**

In order to make the purpose, technical solutions, and advantages of the present invention clearer, the technical solutions of the present invention will be clearly and completely described through implementations with reference to the accompanying drawings in the embodiments of the present invention. Obviously, the described embodiments are some embodiments of the present invention, rather than all the embodiments. Based on the basic concepts disclosed and prompted by the embodiments of the present invention, all other embodiments obtained by those skilled in the art fall within the protection scope of the present invention.

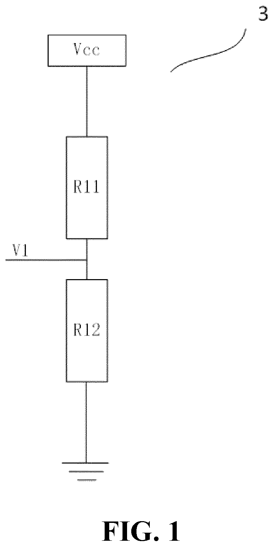

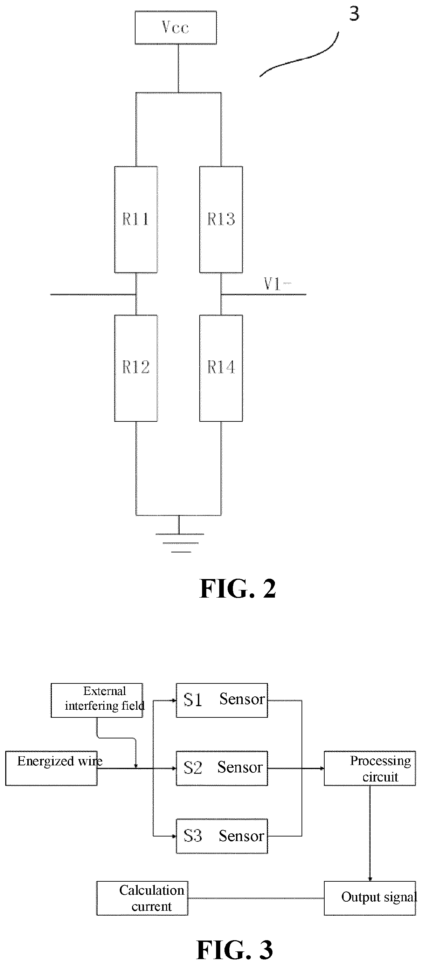

Referring to FIG. 1, which is a schematic connection diagram of magnetic resistors in an existing single current sensor. Referring to FIG. 2, which is a schematic connection diagram of magnetic resistors in another existing single current sensor.

The magnetic resistors of the current sensor in FIG. 1 are in a half-bridge connection manner. The half-bridge structure 3 includes two magnetic resistors R11 and R12 with opposite sensing directions.

The magnetic resistors of the current sensor in FIG. 2 are in a full-bridge connection manner. In the full-bridge structure 3, magnetic resistors located in the same half-bridge have opposite sensing directions, and magnetic resistors located at diagonal positions of different half-bridges have the same sensing directions. In other words, R11 and R12 located in the same half-bridge have opposite sensing directions, R13 and R14 located in the same half-bridge have opposite sensing directions, R11 and R14 located in different half-bridges have the same sensing directions, and R13 and R12 located in different half-bridges have the same sensing directions.

The current sensor measures a current by using the Biot-Savart's law. Generally speaking, when a current of an energized straight wire is I, the magnetic field intensity at a vertical distance r from the wire is H, and $H=I/(2\pi r)$. The magnetic resistor in the current sensor is designed through a process so that its resistance value within a certain range is positively related to the intensity of a magnetic field at its position. The sensing directions of the magnetic resistors R11 and R12 on the same half-bridge are opposite, and therefore, magnetoresistance values of the two magnetic resistors at the distance r can be calculated, which are respectively:

$$R11 = R0 - kH = R0 - \frac{kI}{2\pi r},$$

$$R12 = R0 + kH = R0 + \frac{kI}{2\pi r},$$

wherein R0 is the magnetoresistance value in the absence of a magnetic field, and k is a constant.

At this time, a half-bridge output signal Vh or a full-bridge output signal Vf of the current sensor can be calculated as:

$$Vh = \frac{R12}{R11+R12}Vcc = \frac{R0+\dfrac{kI}{2\pi r}}{2R0}Vcc = \frac{1}{2}Vcc + \frac{kI}{4R0\pi r}Vcc \ ,$$

$$Vf = \left(\frac{R12}{R11+R12} - \frac{R11}{R11+R12}\right)Vcc = \left(\frac{R0+\dfrac{kI}{2\pi r}}{2R0} - \frac{R0-\dfrac{kI}{2\pi r}}{2R0}\right)Vcc = \frac{kI}{2R0\pi r}Vcc \ .$$

As can be known according to the signals Vh and Vf, the output signal of the current sensor is positively related to the current I of the energized straight wire. In other words, the output signal of the current sensor is positively related to the intensity of the magnetic field near the current sensor. Finally, the magnitude of the current intensity can be obtained according to an output voltage signal.

However, in practical applications, a magnetic field signal detected by a magnetic resistor in the current sensor not only includes an induced magnetic field generated by the current, but also includes a magnetic interfering field. Therefore, the output signal of the current sensor further includes noise from the interfering field, which affects the test precision.

In order to solve the problems of the prior art, an embodiment of the present invention provides a magnetic sensor apparatus for measuring a current, which can eliminate an error of a linear interfering field that changes uniformly within the small range and reduce the impact of the interfering field on the current measurement. Specifically, for the current sensor including a plurality of magnetic resistors, an interval between the magnetic resistors is relatively small, and therefore, the non-uniform magnetic interfering field can be approximately considered as a uniformly changing linear interfering field within the small range. Through simple addition, subtraction, multiplication, and division, the non-uniform magnetic interfering field can be eliminated. Based on this, the magnetic sensor apparatus is provided with magnetic resistors at a plurality of positions, and an algorithm is matched to achieve cancellation of a uniform magnetic interfering field and a non-uniform magnetic interfering field.

The magnetic sensor apparatus provided in this embodiment includes: a magnetic field generation portion, the magnetic field generation portion being used for generating a magnetic field; a magnetic sensor portion, the magnetic sensor portion being used for sensing the magnetic field generated by the magnetic field generation portion; and a signal processing portion, the signal processing portion being used for processing a magnetic field signal sensed by the magnetic sensor portion. The magnetic sensor portion includes a first magnetic sensor arranged at a first position, a second magnetic sensor arranged at a second position, and a third magnetic sensor arranged at a third position. The first position, the second position, and the third magnetic sensor are on the same horizontal line and are arranged at equal intervals. Magnetic fields generated by the magnetic field generation portion at the three different positions are different. The signal processing portion includes a first differential circuit, a second differential circuit, and a third differential circuit. The first differential circuit generates a first difference between a first signal sensed and output by the first magnetic sensor and a second signal sensed and output by the second magnetic sensor. The second differential circuit generates a second difference between the second signal and a third signal sensed and output by the third magnetic sensor. The third differential circuit generates a differential measurement signal on the basis of a difference between the first difference and the second difference.

Optionally, the magnetic sensor portion includes a plurality of magnetic sensors, wherein sensing directions of the various magnetic sensors are parallel or anti-parallel.

Optionally, the magnetic field generation portion includes an energized wire or a permanent magnet for generating a regular magnetic field.

Optionally, the magnetic sensor portion and the signal processing portion are integrated and packaged into an independent device; or, the magnetic field generation portion, the magnetic sensor portion, and the signal processing portion are integrated and packaged into an independent device.

Referring to FIG. 3, which is a schematic diagram of a magnetic sensor apparatus according to an embodiment of the present invention. The magnetic sensor apparatus includes an energized wire, a plurality of sensors, and a processing circuit. The sensors are magnetic sensors, and the magnetic sensors include magnetic resistors. Specifically, optionally, the magnetic field generation portion includes the energized wire, the magnetic sensor portion includes the plurality of magnetic sensors, and the signal processing portion includes the processing circuit.

As can be seen according to FIG. 3, under the combined action of an induced magnetic field and an external interfering field, the plurality of sensors S 1 to S3 respectively generate their own output signals. After these signals are input to the processing circuit, a final output signal is obtained through operations of an amplifier and an addition and subtraction portion, which is then converted into a current intensity signal through calculation. Illustration will be made below in conjunction with embodiments.

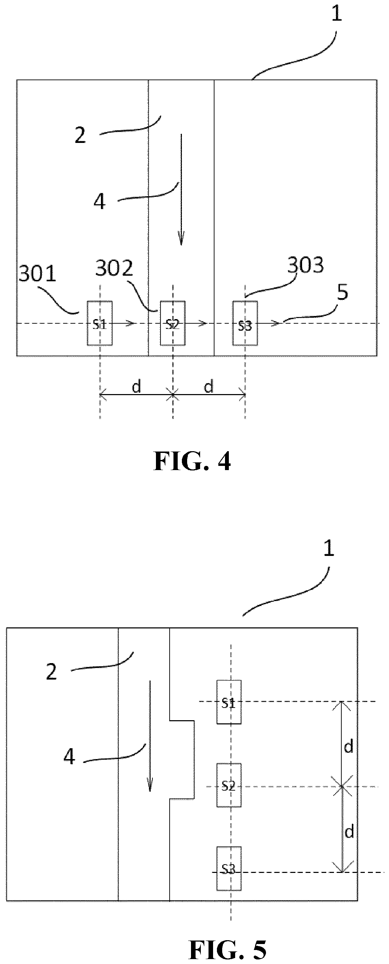

Referring to FIG. 4, which is a schematic diagram of another magnetic sensor apparatus according to an embodiment of the present invention. As shown in FIG. 4, a direction of a current flowing into an energized wire 2 in a magnetic sensor apparatus 1 is an arrow 4. The magnetic sensor apparatus 1 includes three magnetic sensors 301, 302, and 303. The three magnetic sensors 301, 302, and 303 are arranged at three positions S1, S2, and S3 on the same straight line. That is, the magnetic sensor 301 is arranged at the position S1, the magnetic sensor 302 is arranged at the position S2, and the magnetic sensor 303 is arranged at the position S3.

The magnetic sensors at adjacent positions have equal distances on the straight line, for example, an interval between adjacent positions is d. The three magnetic sensors 301, 302, and 303 may have exactly the same sensing directions. For example, an arrow 5 in FIG. 4 indicates the sensing direction. In other embodiments, optionally, at least two magnetic sensors among the three magnetic sensors may have opposite sensing directions. It is understandable that if the magnetic sensors have opposite sensing directions, addition of signals is changed to subtraction of signals.

Assuming that the intensity of the current flowing into the energized wire 2 is I, the linear interfering field existing in the sensing direction can be considered as a combined field of a gradient magnetic interfering field Hg (variable magnetic field per unit distance) and a uniform magnetic interfering field Hu, and output signals V1, V2, and V3 of the 3 magnetic sensors can be obtained, which are respectively,

$$V1 = aI + nHu,$$

$$V2 = bI + n(Hu + Hg),$$

$$V3 = cI + n(Hu + 2Hg),$$

wherein a, b, c, and n are all constants, a is a coefficient of the energizing current to the output voltage of the magnetic sensor 301, b is a coefficient of the energizing current to the output voltage of the magnetic sensor 302, c is a coefficient of the energizing current to the output voltage of the magnetic sensor 303, and n is a coefficient of the interfering field to the output voltage of the magnetic sensor, a, b, c, and n may be detected in advance and stored in the processing circuit.

Addition and subtraction operations are performed in the processing circuit to obtain a final output signal Vout. The algorithm is as follows:

$$Vout = (V2 - V1) - (V3 - V2) = 2V2 - (V1 + V3) = (2b - a - c)I.$$

Therefore, the current intensity I is calculated. Obviously, the current intensity I completely eliminates the impact of the external interfering field and greatly improves the detection precision.

It is understandable that the calculation process of the final actual output signal Vout in the magnetic sensor apparatus may be a difference between the two differential signals in the above expression, or the calculation process of the final actual output signal Vout in the magnetic sensor apparatus may be a difference of 2V2 and (V1+V3), or the calculation process of the final actual output signal Vout in the magnetic sensor apparatus may also be a difference between the V2 signal and an average number of (V1+V3).

It should be understood that in the embodiment of the present invention, the straight line where the magnetic sensors are located may be in any direction except parallel to the direction of the energized wire, that is, the straight line where the magnetic sensors are located is not parallel to the direction of the energized wire. On this basis, the above changes all fall within the protection scope of the present invention. The reason is that if the straight line where the magnetic sensors are located is parallel to the direction of the energized wire, induced magnetic fields of currents at the positions of the various magnetic sensors are the same. In this way, the constants in the output signals V1, V2 and V3 are a=b=c, and after Vout is calculated in the processing circuit, the finally obtained output signal Vout is 0, and subsequent current calculation cannot be performed.

In other embodiments, if the straight line where the magnetic sensors are located is parallel to the direction of the energized wire, for the effectiveness of the magnetic sensor apparatus, the structure may be adjusted so that the induced magnetic fields of the currents at the positions of the magnetic sensors are different. The arrangement of the magnetic sensors may be adjusted to make it diversified, and the shape of the energized wire may also be modified to change the magnitudes of the induced magnetic fields of the currents at the positions of the magnetic sensors.

Referring to FIG. 5, which is a schematic diagram of another magnetic sensor apparatus according to an embodiment of the present invention. As shown in FIG. 5, a side wall of an energized wire 2 has a plurality of protrusions, and magnetic sensors are located in a direction of one side to which the plurality of protrusions of the energized wire 2 are facing.

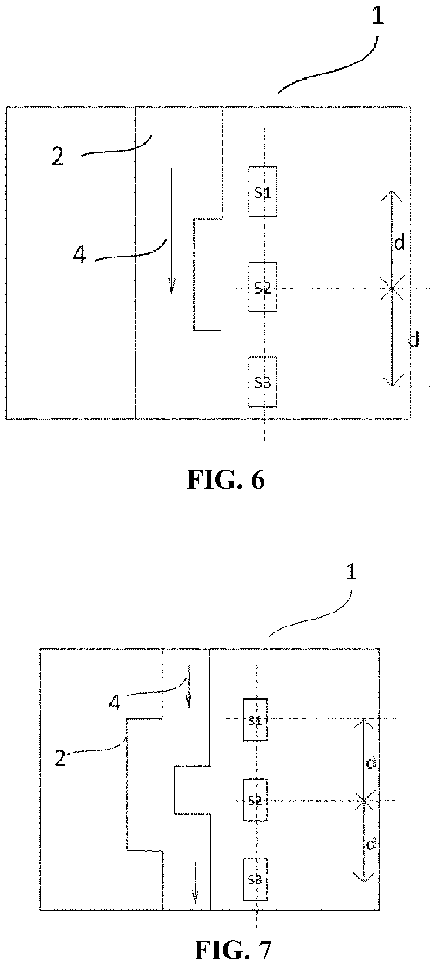

Referring to FIG. 6, which is a schematic diagram of another magnetic sensor apparatus according to an embodiment of the present invention. As shown in FIG. 6, a side wall of an energized wire 2 has a plurality of recesses, and magnetic sensors are located in a direction of one side to which the plurality of recesses of the energized wire 2 are facing.

Referring to FIG. 7, which is a schematic diagram of another magnetic sensor apparatus according to an embodiment of the present invention. As shown in FIG. 7, an energized wire 2 has a plurality of bent regions, and magnetic sensors are located on one side of the energized wire 2.

By adjusting the shape of the energized wire 2 or the arrangement of the magnetic sensors, the induced magnetic fields of the currents at the positions of the magnetic sensors arranged in the direction parallel to the energized wire can be different. It is understandable that in order to achieve different induced magnetic fields of the currents at the positions of the magnetic sensors, the arrangement of the magnetic sensors is not limited to those shown in FIG. 5 to FIG. 7 above. The shape of the energized wire may also be changed in many other ways, as long as the magnitudes of the induced magnetic fields of the currents at the positions of the magnetic sensors can be different.

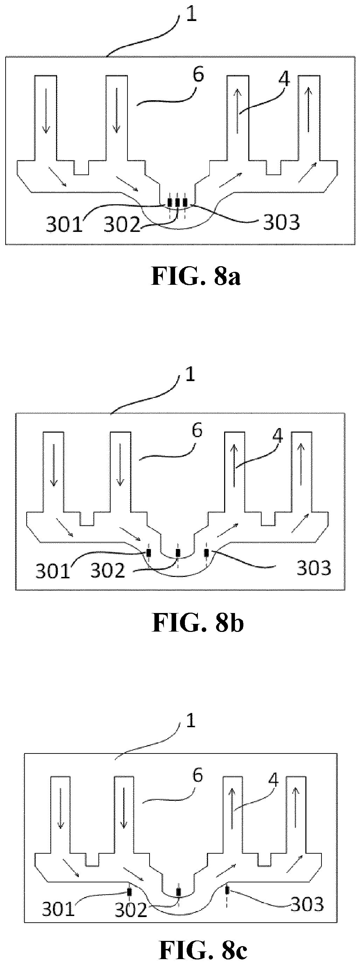

In practical applications, the energized wire is often not arranged in a straight line but bent into various arcs. Especially, the energized wire of a chip-type current sensor has various bending shapes. As shown in FIG. 8a, FIG. 8b, and FIG. 8c, they are schematic diagrams of 3 different kinds of energized wires 6 in the current sensors. The energized wire 6 may also be referred to as a detection copper bar.

The three magnetic sensors 301, 302, and 303 may be located at different positions of the energized wire 6. As shown in FIG. 8a, vertical projections of the three magnetic sensors 301, 302, and 303 on a plane where the energized wire 6 is located are located inside a bent region of the energized wire 6. As shown in FIG. 8b, the vertical projections of the three magnetic sensors 301, 302, and 303 on the plane where the energized wire 6 is located partially overlap the energized wire 6. As shown in FIG. 8c, for the vertical projections of the three magnetic sensors 301, 302, and 303 on the plane where the energized wire 6 is located, at least one of them partial overlaps the energized wire 6, and at least one of them is located outside the bent region of the energized wire 6. The direction of the current in the energized wire is 4.

Due to the shape specificity of the energized wire 6, the induced magnetic fields of the currents at the positions of these magnetic sensors are different, and the magnetic interfering field has the form described in the corresponding embodiment of FIG. 4, so the method of the embodiment shown in FIG. 4 is adopted, which can cancel the impact of the magnetic interfering field on the current measurement. For the energized wire 6 with a specific shape, the distributions of the three magnetic sensors are different, and coefficients of the output voltages to the measured current are different, that is, the constants a, b, and c change, and the cancellation effects to the magnetic interfering field are also different. Therefore, those skilled in the art can reasonably design the distributions of the magnetic sensors and the shape of the energized wire according to actual situations.

The magnetic sensor apparatus provided by the embodiment of the present invention may be used to eliminate the impact of a magnetic interfering field on current measurement. An output signal of the magnetic sensor usually includes a measured magnetic field and a magnetic interfering field, and the magnetic interfering field includes a uniform magnetic interfering field and a non-uniform magnetic interfering field. In the embodiment of the present invention, the use of magnetic sensors located at N positions and a compensation algorithm can simultaneously eliminate the uniform magnetic interfering field and the non-uniform magnetic interfering field, thereby improving the anti-interference ability and current detection precision of the current sensor.

The magnetic sensor apparatus provided in this embodiment includes: a magnetic field generation portion, the magnetic field generation portion being used for generating a magnetic field; a magnetic sensor portion, the magnetic sensor portion being used for sensing the magnetic field generated by the magnetic field generation portion; and a signal processing portion, the signal processing portion being used for processing a magnetic field signal sensed by the magnetic sensor portion. The magnetic sensor portion includes a first magnetic sensor arranged at a first position, a second magnetic sensor arranged at a second position, a third magnetic sensor arranged at a third position, and a fourth magnetic sensor arranged at a fourth position. The first position, the second position, the third position, and the fourth position are on the same horizontal line and are arranged at equal intervals. Alternatively, an interval between the first position and the third position is the same as an interval between the second position and the fourth position, and the interval between the first position and the third position is greater than an interval between the first position and the second position. Magnetic fields generated by the magnetic field generation portion at the four different positions are different. The signal processing portion includes a first differential circuit, a second differential circuit, and a third differential circuit, the first differential circuit generates a first difference between a first signal sensed and output by the first magnetic sensor and a second signal sensed and output by the second magnetic sensor, the second differential circuit generates a second difference between a third signal sensed and output by the third magnetic sensor and a fourth signal sensed and output by the fourth magnetic sensor, and the third differential circuit generates a differential measurement signal on the basis of a difference between the first difference and the second difference. Alternatively, the first differential circuit generates a first difference between a first signal sensed and output by the first magnetic sensor and a third signal sensed and output by the third magnetic sensor, the second differential circuit generates a second difference between a second signal sensed and output by the second magnetic sensor and a fourth signal sensed and output by the fourth magnetic sensor, and the third differential circuit generates a differential measurement signal on the basis of a difference between the first difference and the second difference.

Optionally, the magnetic sensor portion includes a plurality of magnetic sensors, wherein sensing directions of the various magnetic sensors are parallel or anti-parallel.

Optionally, the magnetic field generation portion includes an energized wire or a permanent magnet for generating a regular magnetic field.

Optionally, the magnetic sensor portion and the signal processing portion are integrated and packaged into an independent device; or, the magnetic field generation portion, the magnetic sensor portion, and the signal processing portion are integrated and packaged into an independent device.

Different from the above embodiment, in this embodiment, the magnetic sensor portion includes 4 different positions and 4 magnetic sensors arranged at the 4 different positions. Of course, in other embodiments, the magnetic sensor portion may optionally include more than 4 different positions and a plurality of magnetic sensors arranged at the more than 4 different positions.

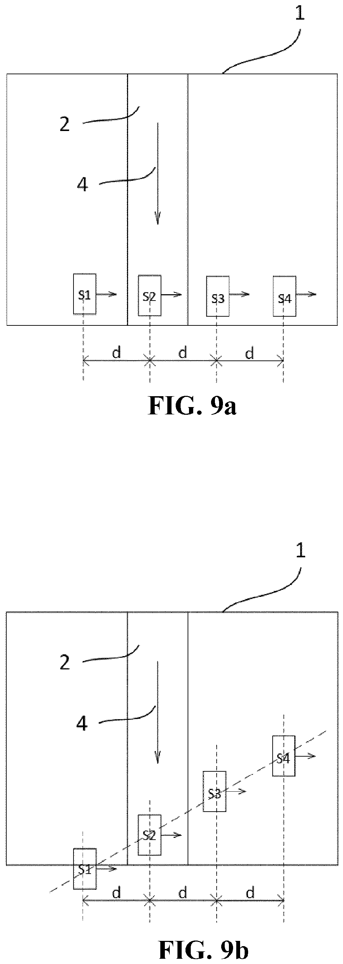

Referring to FIG. 9a, which is a schematic diagram of still another magnetic sensor apparatus according to an embodiment of the present invention. As shown in FIG. 9a, a direction of a current flowing into an energized wire 2 in a magnetic sensor apparatus 1 is an arrow 4. The magnetic sensor apparatus 1 includes 4 different positions S1, S2, S3, and S4. Each position is provided with a magnetic sensor, the 4 different positions are arranged on the same straight line, and the 4 positions are arranged at equal intervals on the straight line. Optionally, the interval is d.

The magnetic sensors at adjacent positions have equal distances on the straight line, and sensing directions of the 4 magnetic sensors may be exactly the same. For example, an arrow on the side of a position S in FIG. 9a shows the sensing direction. In other embodiments, optionally, at least two magnetic sensors among the 4 magnetic sensors may have opposite sensing directions. It is understandable that if the magnetic sensors have opposite sensing directions, addition of signals is changed to subtraction of signals.

Assuming that the intensity of the current flowing into the energized wire 2 is I, the linear interfering field existing in the sensing direction can be considered as a combined field of a gradient magnetic interfering field Hg (variable magnetic field per unit distance) and a uniform magnetic interfering field Hu, and output signals V1, V2, V3, and V4 of the 4 magnetic sensors can be obtained, which are respectively,

$$V1 = aI + nHu,$$

$$V2 = bI + n(Hu + Hg),$$

$$V3 = cI + n(Hu + 2Hg),$$

$$V4 = cI + n(Hu + 3Hg),$$

For the arrangement of the 4 magnetic sensors, addition and subtraction operations may be performed in the processing circuit using the following formula to obtain a final output signal Vout. The formula is as follows:

$$Vout = (V1-V2) - (V3-V4) = (a-b-c+d)I.$$

Alternatively, for the arrangement of the 4 magnetic sensors, addition and subtraction operations may be performed in the processing circuit using the following formula to obtain a final output signal Vout. The formula is as follows:

$$Vout = (V1-V3) - (V2-V4) = (a-b-c+d)I.$$

Therefore, the current intensity I can be calculated by using any of the above formulas of Vout. Obviously, the impact of an external interfering field is eliminated, so that the current intensity I completely eliminates the impact of the external interfering field and greatly improves the detection precision.

Referring to FIG. 9b, which is a schematic diagram of still another magnetic sensor apparatus according to an embodiment of the present invention. FIG. 9b is different from FIG. 9a in that the straight line where the four magnetic sensors are located intersects the energized wire 2 in a non-perpendicular manner. In other embodiments, further referring to FIG. 5 to FIG. 7, the energized wire may adopt the structure of the energized wires shown in FIG. 5 to FIG. 7, and the arrangement direction of the 4 magnetic sensors is parallel to the direction of the energized wires. The processing circuit uses a corresponding algorithm to simultaneously eliminate the interference effects of the uniform external field and the non-uniform external field without significantly reducing the signal generated by a magnetic field to be measured.

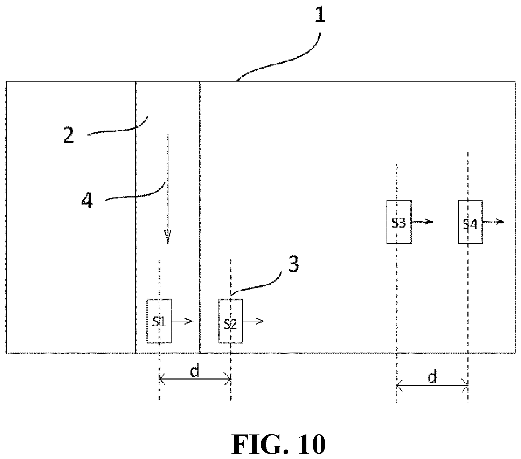

Referring to FIG. 10, which is a schematic diagram of still another magnetic sensor apparatus according to an embodiment of the present invention. Different from the above embodiment, as shown in FIG. 10, a plurality of positions are not located on the same straight line, instead, positions S 1 and S2 are located on the same straight line and close to the energized wire 2, and positions S3 and S4 are located on the same straight line and far away from the energized wire 2. Magnetic sensors are arranged at the positions S1, S2, S3, and S4. The positions S3 and S4 are far away from the energized conductor 2, and therefore, induced magnetic fields generated by currents in the energized conductor 2 at the positions are very small. Alternatively, it can be considered that the induced magnetic fields generated by the currents at the positions S3 and S4 are almost the same.

Then, output signals V1, V2, V3, and V4 corresponding to the magnetic sensors located at the four positions are respectively,

$$V1 = aI + nHu, V2 = bI + n(Hu + Hg),$$

$$V3 = cI + n(Hu + H0), V4 = cI + n(Hu + H0 + Hg),$$

wherein the value of c is very small; and due to the different positions of S2 and S3, there is a difference in initial magnetic interfering field values of the magnetic sensors at the 4 four positions, and the difference is H0. It is understandable that there is no difference in the initial magnetic interfering field values of the magnetic sensors located at the 4 positions on the same straight line or the difference is close to 0.

Addition and subtraction operations are performed in the processing circuit to obtain a final output signal Vout. The algorithm is as follows:

$$Vout = (V1 - V2) - (V3 - V4) = (a - b)I,$$

or,

$$Vout = (V1 - V3) - (V2 - V4) = (a - b)I.$$

Therefore, the current intensity I is calculated. Obviously, the current intensity I completely eliminates the impact of the external interfering field and greatly improves the detection precision.

As can be seen from FIG. 10, if an interval between projections of the magnetic sensors at the positions S1 and S2 in the sensing direction is equal to an interval between projections of the magnetic sensors at the positions S3 and S4 in the sensing direction, even if the 4 positions are not on the same straight line, the function of eliminating interference can still be achieved. These interferences may include the non-uniform magnetic field generated by the circuit.

The magnetic sensor apparatus provided by the embodiment of the present invention can simultaneously eliminate the interferences of a uniform external field and a non-uniform external field on the current sensor, and improve the current detection precision. When applied in the field of current sensors, it can adapt to different complex application environments and eliminate various forms of magnetic interfering fields.

For any of the above embodiments, optionally, the magnetic field generation portion includes a magnetic source that can generate a regular magnetic field, such as an energized wire or a permanent magnet. Optionally, the magnetic sensor portion and the signal processing portion are packaged into a single device and are located above, to the side, or above the side of the magnetic field generation portion. Optionally, the magnetic sensor in the magnetic sensor portion is a magnetoresistive sensor, a Hall effect sensor, a fluxgate sensor, or a coil type sensor.

It should be noted that in various embodiments of the present invention, the sensing direction of the magnetic sensor only selects a specific direction as an example, such as the horizontal direction. But in fact, the sensing direction of the magnetic sensor may be any direction, as long as an induced magnetic field of a conductor to be measured has a magnetic field component in the selected sensing direction of the magnetic sensor.

It should be noted that, the above descriptions are merely the preferred embodiments and used technical principles of the present invention. A person skilled in the art should understand that the present invention is not limited to the specific embodiments herein, and for a person skilled in the art, various obvious variations, readjustments, mutual combinations, and replacements may be made without departing from the protection scope of the present invention. Therefore, the present invention is described in detail through the above embodiments; however, the present invention is not merely limited to the above embodiments, and without departing from the conception of the present invention, more other equivalent embodiments may further be included, and the scope of the present invention is defined by the appended claims.

**Claims**

1. A magnetic sensor apparatus, comprising:

   a magnetic field generation portion, the magnetic field generation portion being used for generating a magnetic field;
   a magnetic sensor portion, the magnetic sensor portion being used for sensing the magnetic field generated by the magnetic field generation portion; and
   a signal processing portion, the signal processing portion being used for processing a magnetic field signal sensed by the magnetic sensor portion;
   wherein the magnetic sensor portion comprises a first magnetic sensor arranged at a first position, a second magnetic sensor arranged at a second position, and a third magnetic sensor arranged at a third position, and magnetic fields generated by the magnetic field generation portion at the three different positions are different; and
   the signal processing portion comprises a first differential circuit, a second differential circuit, and a third differential circuit, the first differential circuit generates a first difference between a first signal sensed and output by the first magnetic sensor and a second signal sensed and output by the second magnetic sensor, the second differential circuit generates a second difference between the second signal and a third signal sensed and output by the third magnetic sensor, and the third differential circuit generates a differential measurement signal on the basis of a difference between the first difference and the second difference.

2. The magnetic sensor apparatus according to claim 1, wherein the first position, the second position, and the third position are on the same horizontal line and are arranged at equal intervals.

3. The magnetic sensor apparatus according to claim 1 or 2, wherein the magnetic sensor portion comprises a plurality of magnetic sensors, and sensing directions of the various magnetic sensors are parallel or anti-parallel.

4. The magnetic sensor apparatus according to claim 1, wherein the magnetic field generation portion comprises an energized wire or a permanent magnet for generating a regular magnetic field.

5. The magnetic sensor apparatus according to claim 1, wherein the magnetic sensor portion and the signal processing portion are integrated and packaged into an independent device; or
   the magnetic field generation portion, the magnetic sensor portion, and the signal processing portion are integrated and packaged into an independent device.

6. A magnetic sensor apparatus, comprising:

   a magnetic field generation portion, the magnetic field generation portion being used for generating a magnetic field;
   a magnetic sensor portion, the magnetic sensor portion being used for sensing the magnetic field generated by the magnetic field generation portion; and
   a signal processing portion, the signal processing portion being used for processing a magnetic field signal sensed by the magnetic sensor portion;
   wherein the magnetic sensor portion comprises a first magnetic sensor arranged at a first position, a second magnetic sensor arranged at a second position, a third magnetic sensor arranged at a third position, and a fourth magnetic sensor arranged at a fourth position;
   magnetic fields generated by the magnetic field generation portion at the four different positions are different; and

the signal processing portion comprises a first differential circuit, a second differential circuit, and a third differential circuit, the first differential circuit generates a first difference between a first signal sensed and output by the first magnetic sensor and a second signal sensed and output by the second magnetic sensor, the second differential circuit generates a second difference between a third signal sensed and output by the third magnetic sensor and a fourth signal sensed and output by the fourth magnetic sensor, and the third differential circuit generates a differential measurement signal on the basis of a difference between the first difference and the second difference; or,

the first differential circuit generates a first difference between a first signal sensed and output by the first magnetic sensor and a third signal sensed and output by the third magnetic sensor, the second differential circuit generates a second difference between a second signal sensed and output by the second magnetic sensor and a fourth signal sensed and output by the fourth magnetic sensor, and the third differential circuit generates a differential measurement signal on the basis of a difference between the first difference and the second difference.

7. The magnetic sensor apparatus according to claim 6, wherein the first position, the second position, the third position, and the fourth position are on the same horizontal line and are arranged at equal intervals, or an interval between the first position and the third position is the same as an interval between the second position and the fourth position, and the interval between the first position and the third position is greater than an interval between the first position and the second position.

8. The magnetic sensor apparatus according to claim 6 or 7, wherein the magnetic sensor portion comprises a plurality of magnetic sensors, and sensing directions of the various magnetic sensors are parallel or anti-parallel.

9. The magnetic sensor apparatus according to claim 6, wherein the magnetic field generation portion comprises an energized wire or a permanent magnet for generating a regular magnetic field.

10. The magnetic sensor apparatus according to claim 6, wherein the magnetic sensor portion and the signal processing portion are integrated and packaged into an independent device; or
the magnetic field generation portion, the magnetic sensor portion, and the signal processing portion are integrated and packaged into an independent device.

**FIG. 1**

3

Vcc

R11    R13

V1

R12    R14

**FIG. 2**

External interfering field

S1    Sensor

Energized wire

S2    Sensor

Processing circuit

S3    Sensor

Calculation current

Output signal

**FIG. 3**

**FIG. 4**

**FIG. 5**

FIG. 6

FIG. 7

FIG. 8a

FIG. 8b

FIG. 8c

FIG. 9a

FIG. 9b

**FIG. 10**

## INTERNATIONAL SEARCH REPORT

| | International application No. |
|---|---|
| | **PCT/CN2022/118641** |

**A. CLASSIFICATION OF SUBJECT MATTER**

G01R 33/09(2006.01)i; G01R 33/02(2006.01)i

According to International Patent Classification (IPC) or to both national classification and IPC

**B. FIELDS SEARCHED**

Minimum documentation searched (classification system followed by classification symbols)

G01R

Documentation searched other than minimum documentation to the extent that such documents are included in the fields searched

Electronic data base consulted during the international search (name of data base and, where practicable, search terms used)

CNABS; CNTXT; CNKI; WPABS; DWPI; USTXT; WOTXT; EPTXT: 江苏多维科技有限公司, 郭海平, 宋晨, 陈晔, 沈卫锋, 薛松生, 传感器, 差分, 磁场, 干扰, 第三, 第四, sensor?, differen+, magnetic, interference

**C. DOCUMENTS CONSIDERED TO BE RELEVANT**

| Category* | Citation of document, with indication, where appropriate, of the relevant passages | Relevant to claim No. |
|---|---|---|
| PX | CN 113945873 A (JIANGSU MULTIDIMENSION TECHNOLOGY CO., LTD.) 18 January 2022 (2022-01-18) claims 1-10 | 1-10 |
| X | CN 109141482 A (INFINEON TECHNOLOGIES AG) 04 January 2019 (2019-01-04) description, paragraphs [0027]-[0078], and figures 1-7 | 1-10 |
| X | CN 204008811 U (ZHEJIANG MAGTRON INTELLIGENT TECHNOLOGY CO., LTD.) 10 December 2014 (2014-12-10) description, paragraphs [0027]-[0044], and figures 1-4 | 6-10 |
| A | CN 102565726 A (NXP B.V.) 11 July 2012 (2012-07-11) entire document | 1-10 |
| A | JP 2016217868 A (MITSUBISHI ELECTRIC CORP.) 22 December 2016 (2016-12-22) entire document | 1-10 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **29 October 2022** | **18 November 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/118641**

| Patent document cited in search report | | | Publication date (day/month/year) | Patent family member(s) | | | Publication date (day/month/year) |
|---|---|---|---|---|---|---|---|
| CN | 113945873 | A | 18 January 2022 | None | | | |
| CN | 109141482 | A | 04 January 2019 | US | 2018364066 | A1 | 20 December 2018 |
| | | | | DE | 102018114131 | A1 | 20 December 2018 |
| | | | | CN | 109141482 | B | 16 March 2021 |
| CN | 204008811 | U | 10 December 2014 | None | | | |
| CN | 102565726 | A | 11 July 2012 | EP | 2466325 | A1 | 20 June 2012 |
| | | | | US | 2012153942 | A1 | 21 June 2012 |
| | | | | EP | 2466325 | B1 | 10 July 2013 |
| | | | | US | 8669761 | B2 | 11 March 2014 |
| JP | 2016217868 | A | 22 December 2016 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 109313223 A
- CN 111308154 A